Europäisches Patentamt

European Patent Office

Office européen des brevets

(19)

(11) **EP 0 401 562 B1**

(12) ## EUROPÄISCHE PATENTSCHRIFT

(45) Veröffentlichungstag und Bekanntmachung des Hinweises auf die Patenterteilung:
**28.08.1996 Patentblatt 1996/35**

(51) Int Cl.$^6$: **H03H 17/06**

(21) Anmeldenummer: **90109171.0**

(22) Anmeldetag: **16.05.1990**

(54) **Anordnung zur Umsetzung eines Signals mit einer ersten Abtastrate in ein Signal mit einer zweiten Abtastrate**

Device for converting a signal with a first sampling rate to a signal with a second sampling rate

Dispositif de conversion d'un signal ayant une première fréquence d'échantillonnage en un signal ayant une deuxième fréquence d'échantillonnage

(84) Benannte Vertragsstaaten:
**AT DE FR GB IT**

(30) Priorität: **09.06.1989 DE 3918866**

(43) Veröffentlichungstag der Anmeldung:
**12.12.1990 Patentblatt 1990/50**

(73) Patentinhaber: **BLAUPUNKT-WERKE GMBH**
**31132 Hildesheim (DE)**

(72) Erfinder:
• **Vogt, Lothar, Dr.**
**D-3156 Hohenhameln (DE)**

• **Poschen, Dieter**
**D-3200 Hildesheim (DE)**

(56) Entgegenhaltungen:
**EP-A- 0 137 323** **EP-A- 0 305 864**

• **IEEE TRANSACTIONS ON ACOUSTICS, SPEECH, AND SIGNAL PROCESSING, Band ASSP-26, Nr. 6, Dezember 1978, Seiten 508-517, New York, US; H.S. HOU et al.: "Cubic splines for image interpolation and digital filtering"**

**Beschreibung**

Die Erfindung geht aus von einer Anordnung nach der Gattung des Hauptanspruchs.

Verschiedene Signalquellen in digitalen Audiosystemen benutzen unterschiedliche Abtastraten. So beträgt beispielsweise bei CD-Spielern die Abtastrate 44,1 kHz, bei digitalen Audioband-Geräten (DAT) 48 kHz und bei A/D-gewandelten NF-Signalen des UKW-Rundfunks 38 kHz. Für eine einheitliche Verarbeitung der Signale, beispielsweise Filterung oder Digital/Analog-Wandlung, ist jedoch eine einheitliche Abtastrate erforderlich.

Aus der EP 137 323 A2 ist ein Verfahren und eine Vorrichtung zur Umsetzung einer Eingangsabtastfolge in eine Ausgangsabtastfolge bekannt. Bei dem dort vorgestellten Verfahren wird nur ein einziges, einstufiges digitales Filter verwendet. Die Berechnung der Filterkoeffizienten ist von der Zeitdifferenz zwischen benachbarten Abtastwerten der Eingangs- und Ausgangsabtastfolge abhängig.

Aufgabe der vorliegenden Erfindung ist es, eine Anordnung anzugeben, mit welcher unterschiedliche Abtastraten mit hoher Genauigkeit umgesetzt werden können.

Die Anordnung mit den kennzeichnenden Merkmalen des Hauptanspruchs hat den Vorteil, daß die Abtastraten der einzelnen Signalquellen untereinander sowie die einheitliche Abtastrate in keinem bestimmten Zahlenverhältnis zu stehen brauchen. Ferner ist mit der erfindungsgemäßen Anordnung eine ausgezeichnete Signalqualität, insbesondere ein ausgezeichneter Störabstand erzielbar.

Eine der Weiterbildungen sieht vor, daß das Signal mit der ersten Abtastrate über eine Einrichtung zur Überabtastung zuführbar ist. Dadurch ist eine besonders günstige Realisierung der erfindungsgemäßen Anordnung mit Hilfe eines digitalen Signalprozessors möglich, wobei die Takte mit der ersten und der zweiten Abtastrate derart verkoppelt sind, daß sie die gleiche Fehlertoleranz haben.

Durch die in den Unteransprüchen aufgeführten Maßnahmen sind vorteilhafte Weiterbildungen und Verbesserungen der im Hauptanspruch angegebenen Erfindung möglich.

Bei der erfindungsgemäßen Anordnung wird zur Berechnung der Abtastwerte mit der zweiten Abtastrate von einem mathematischen Verfahren Gebrauch gemacht, das an sich unter der Bezeichnung "verallgemeinerte Abtastreihen" bekannt ist. Dazu wird ausgegangen von der Fourier-Transformierten einer Funktion g, die definiert ist durch

$$\hat{g}(v) = (1/2\pi) \int_{-\infty}^{\infty} g(x) \cdot e^{-ivx} dx$$

Dabei ist v eine reelle Zahl und $i = \sqrt{-1}$. Ist $\Phi$ eine zeitbegrenzte Funktion mit der Zeitgrenze $T \geq 0$, i. e. $\Phi(t) = 0$ für $|t| \geq T$, und gilt für die Fourier-Transformierte $\hat{\Phi}$ folgendes:

$$D^j\hat{\Phi}(2\pi k) = \begin{cases} \delta_{j,0} & , \quad k = 0, \\ 0 & , \quad k \neq 0, \end{cases} \quad j = 0, \ldots, r$$

wobei $D^j$ die j-te Ableitung, $\delta_{j0} = 1$ für $j = 0$ und $\delta_{j0} = 0$ für j ungleich 0 ist, so gilt für eine r-fache stetig differenzierbare Funktion f

$$\max \left| \sum_{k=[t/T_0-T]+1}^{[t/T_0+T]} \{f(k \cdot T_0) \cdot \Phi(t/T_0-k)\} - f(t) \right| \leq C \cdot T_0^r \qquad (1)$$

Dabei bedeutet [x] die größte ganze Zahl, die $\leq x$ ist (Gaußklammer). C ist eine von t und $T_0$ unabhängige Konstante und t eine reelle Zahl. Gleichung (1) bedeutet, daß man f durch die Summe approximieren kann und zwar umso besser je kleiner $T_0$ ist. $T_0$ ist in der Praxis kleiner als der durch die Nyquist-Rate des Signals vorgegebene Takt.

Umgeschrieben lautet Gleichung (1):

$$f(t) = \sum_{k=[t/T_0-T]+1}^{[t/T_0+T]} f(k \cdot T_0) \cdot \Phi(t/T_0-k) + R(\Phi;T_0) \qquad (2)$$

Dabei ist $R(\Phi; T_0)$ der Approximationsfehler. Da die Gleichung (2) für alle t gilt, die reelle Zahlen sind, gilt sie insbesondere für $t = n \cdot T_1$, wobei n eine natürliche Zahl ist. Es ergibt sich somit folgendes:

$$f(n \cdot T_1) = \sum_{k=[nT_1/T_0-T]+1}^{[nT_1/T_0+T]} f(k \cdot T_0) \cdot \Phi(n \cdot T_1/T_0 - k) + R(\Phi; T_0) \qquad (3)$$

Gleichung (3) stellt die Berechnung eines Signals $f(n \cdot T_1)$ mit dem gewünschten Abtasttakt $T_1$ aus einem Signal $f(k \cdot T_0)$ dem vorliegenden Abtasttakt $T_0$ dar. Gleichung (3) kann interpretiert werden als ein nichtrekursives Filter mit zeitabhängigen Koeffizienten, die sich als Funktionswerte der Funktion $\Phi$ ergeben.

Als Funktion $\Phi$ haben sich Linearkombinationen sogenannter B-Splines besonders bewährt, denn sie zeichnen sich aus durch

(i) einen kleinen Polynomgrad bei hoher Approximationsgüte und
(i) kleine Zeitgrenze T, woraus sich ergibt, daß die Filterordnung niedrig bleibt.

Die Berechnung der Funktion $\Phi$ geschieht nach folgenden Gleichungen:

$$\Phi(t) = \sum_{l=1}^{s} \gamma_l \cdot B_{p_l}(t)$$

Dabei ist s eine natürliche Zahl. Die Zahlen $p_1$ sind größer gleich 2 mit $p_1$ kleiner $p_2$, ..., $P_{s-1}$ kleiner $p_s$. Die Koeffizienten $\gamma_1$ genügen dem linearen Gleichungssystem nach Vandermonde.

$$\sum_{l=1}^{s} \gamma_l p_l^m = \begin{cases} 1, & m = 0, \\ 0, & m = 1, \ldots s - 1. \end{cases}$$

$B_m$ sind die sogenannten B-Splines. Sie berechnen sich nach den Gleichungen:

$$B_m(t) = \{1/(m-1)!\} \sum_{j=0}^{[m/2-|t|]} (-1)^j \binom{m}{j}(m/2-j-|t|)^{m-1},$$

$|t| \le m/2$, und
$B_m(t) = 0$, $|t| > m/2$,
wobei m eine natürliche Zahl größer als 1 und t eine reelle Zahl ist. So ist beispielsweise $B_2(t) = 1-|t|$ für $|t| \le 1$ und $B_2(t) = 0$ für $|t|>1$. Einfache Realisierungen ergeben sich beispielsweise mit $s = 2$, $p_1 = 4$, $p_2 = 5$ zu

$$\Phi(t) = 5B_4(t) - 4B_5(t)$$

oder mit $s = 3$, $p_1 = 6$, $p_2 = 7$, $p_3 = 8$ zu

$$\Phi(t) = 28B_6(t) - 48B_7(t) + 21B_8(t).$$

Da die Funktion $\Phi$ explizit vorliegt, ist die Auswertung und Berechnung der zeitabhängigen Filter-Koeffizienten in einem Signalprozessor durchführbar. Dieses ist besonders effizient möglich, wenn die in der Formel durch die in der Praxis auftretenden Abtasttakte $T_0$ und $T_1$ vorgegebene Periodizität ausgenutzt wird. So beträgt beispielsweise eine Periode 100, wenn $T_0 = 1/38$ kHz und $T_1 = 1/200$ kHz ist. Die zur Berechnung von $f(T_1)$ und $f(101 \cdot T_1)$ in Gleichung (3) auftretenden Filter-Koeffizienten sind gleich.

Die Filter-Koeffizienten können für gegebene Verhältnisse der Abtastraten vorab berechnet und in einem Koeffizienten-Speicher abgelegt werden. Außerdem ist an den Koeffizienten erkennbar, wann jeweils ein anderer Abtastwert $f(k \cdot T_0)$ neu hinzukommen muß. In diesem Zusammenhang sei darauf hingewiesen, daß das digitale Filter ähnlich einem verschiebbaren Fenster die jeweils erforferliche Anzahl von Abtastwerten erfaßt.

Ein Ausführungsbeispiel der Erfindung ist in der Zeichnung anhand mehrerer Figuren dargestellt und in der nachfolgenden Beschreibung näher erläutert. Es zeigt:

Fig. 1    ein Blockschaltbild eines ersten Ausführungsbeispiels,

Fig. 2    ein Blockschaltbild eines digitalen Filters in der erfindungsgemäßen Anordnung nach Fig. 1,

Fig. 3    eine Darstellung der Funktionen einer Steuerschaltung in der erfindungsgemäßen Anordnung nach Fig. 1,

Fig. 4    ein Blockschaltbild eines zweiten Ausführungsbeispiels,

Fig. 5    ein Blockschaltbild einer Schaltungsanordnung zur Erzeugung von Taktsignalen und

Fig. 6    ein Blockschaltbild eines dritten Ausführungsbeispiels.

Gleiche Teile sind in den Figuren mit gleichen Bezugszeichen versehen. Außerdem sind die Taktsignale $T_0$ und $T_1$ gleichlautend mit den entsprechenden Abtasttaktperioden $T_0$ und $T_1$ bezeichnet.

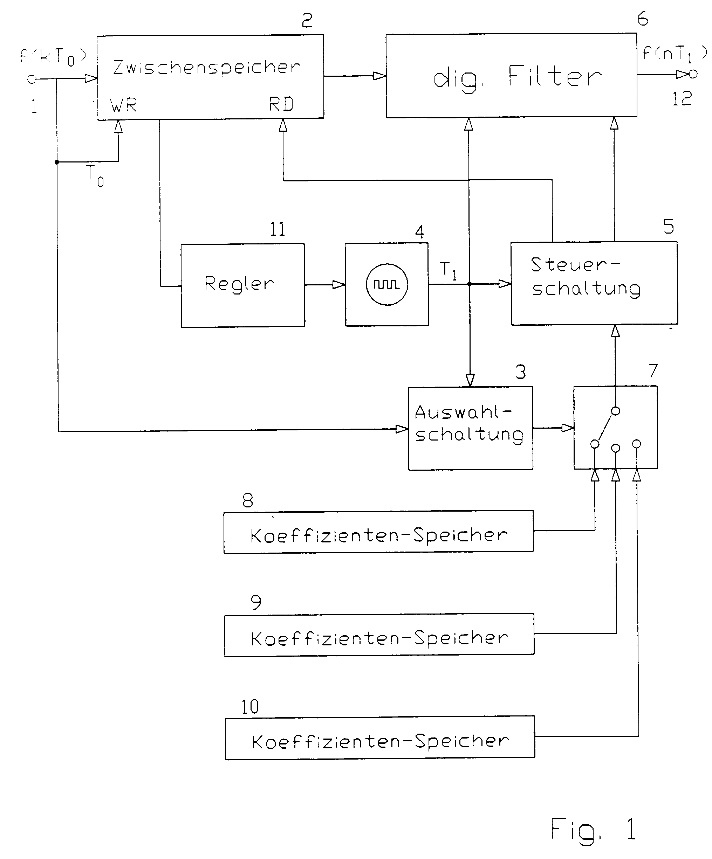

Der Anordnung nach Fig. 1 wird das Signal $f(k \cdot T_0)$ mit einem ersten Abtasttakt $T_0$ zugeführt. Es gelangt von dort in einen Zwischenspeicher 2. Ein aus dem Signal gewonnenes Taktsignal $T_0$ steuert über einen Eingang WR das Einschreiben des Signals in den Zwischenspeicher 2 und wird zu einer Auswahlschaltung 3 geleitet. Ein Taktsignal für die zweite Abtastrate $T_1$ wird in einem Generator 4 erzeugt und einer Steuerschaltung 5, einem digitalen Filter 6 und der Auswahlschaltung 3 zugeführt.

Die Auswahlschaltung 3 erkennt, welchen von mehreren möglichen Werten der Abtasttakt $T_0$ aufweist und steuert einen Umschalter 7 dementsprechend, so daß aus einem der Koeffizienten-Speicher 8, 9, 10 jeweils diejenigen Koeffizienten ausgelesen werden, welche zu dem jeweiligen Verhältnis zwischen $T_0$ und $T_1$ passen. In Fig. 1 sind lediglich drei Koeffizienten-Speicher 8, 9, 10 dargestellt. Je nach Erfordernissen können auch mehr Speicher vorgesehen sein. Der Übersichtlichkeit halber wurde die Auswahl der Koeffizienten mit Hilfe eines Umschalters 7 dargestellt. Bei der Verwendung von modernen Speicherbausteinen wird jedoch in der Praxis eine entsprechende Adressensteuerung zum Auslesen der in einem Speicher unter verschiedenen Adressen abgelegten Koeffizienten vorgesehen werden.

Mit Hilfe der Steuerschaltung 5 werden die Koeffizienten dem digitalen Filter 6 zugeführt und die jeweils vom Signal $f(k \cdot T_0)$ benötigten Abtastwerte aus dem Zwischenspeicher 2 augelesen. Dazu wird einem Lesesteuereingang RD des Zwischenspeichers 2 von der Steuerschaltung 5 ein Signal zugeführt, das bereits im Raster des Taktes $T_1$ liegt.

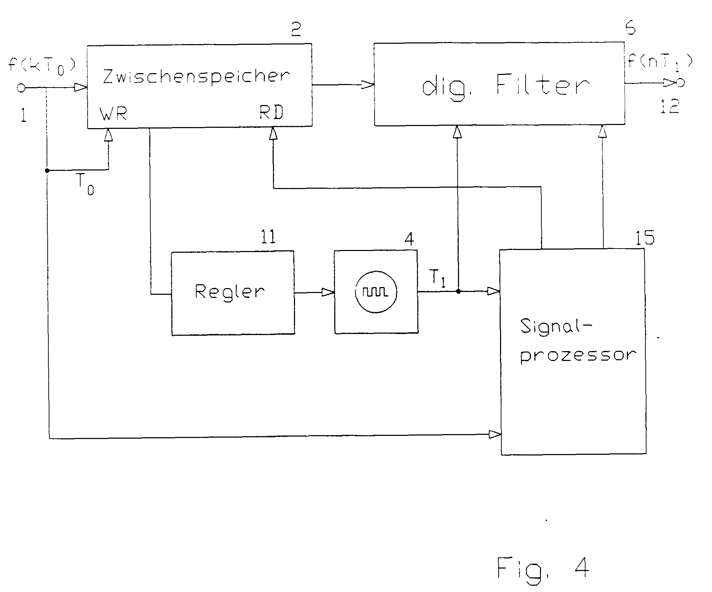

Dabei kann es vorkommen, daß der Generator 4 nicht genau auf derjenigen Frequenz schwingt, welche dem Verhältnis $T_0/T_1$ entspricht, für welches die Koeffizienten abgelegt sind oder berechnet werden - wie bei dem Ausführungsbeispiel nach Fig. 4. Entsprechend einer derartigen Abweichung liest die Steuerschaltung 5 mehr oder weniger Abtastwerte aus dem Zwischenspeicher aus, als vom Eingang 1 zugeführt werden. Bei der Anordnung nach Fig. 1 ist daher vorgesehen, die Frequenz des Generators 4 in Abhängigkeit vom Füllungsgrad des Zwischenspeichers 2 nachzuregeln. Dazu ist ein entsprechender Ausgang des Zwischenspeichers 2 über einen Regler 11 mit einem Steuereingang des Generators 4 verbunden. Der damit geregelte Regelkreis ist derart ausgelegt, daß im eingeschwungenen Zustand der Zwischenspeicher zur Hälfte gefüllt ist.

Fig. 2 zeigt ein Blockschaltbild des digitalen Filters 6. Von dem Zwischenspeicher 2 (Fig. 1) werden dem digitalen Filter 6 Abtastwerte $f(k \cdot T_0)$ des Signals zugeführt. Dabei wird jeweils ein Abtastwert einer der Multiplizierschaltungen 61 bis 61 zugeführt. Jeweils einer der Multiplizierschaltungen 61 bis 61 wird ein Koeffizient $a_{n,k_1}$ bis $a_{n,k_1}$ zugeleitet. Die Ergebnisse der Multiplikationen werden in einer Summierschaltung 13 summiert, an deren Ausgang 12 das Signal $f(n \cdot T_1)$ mit der zweiten Abtastrate abgenommen werden kann.

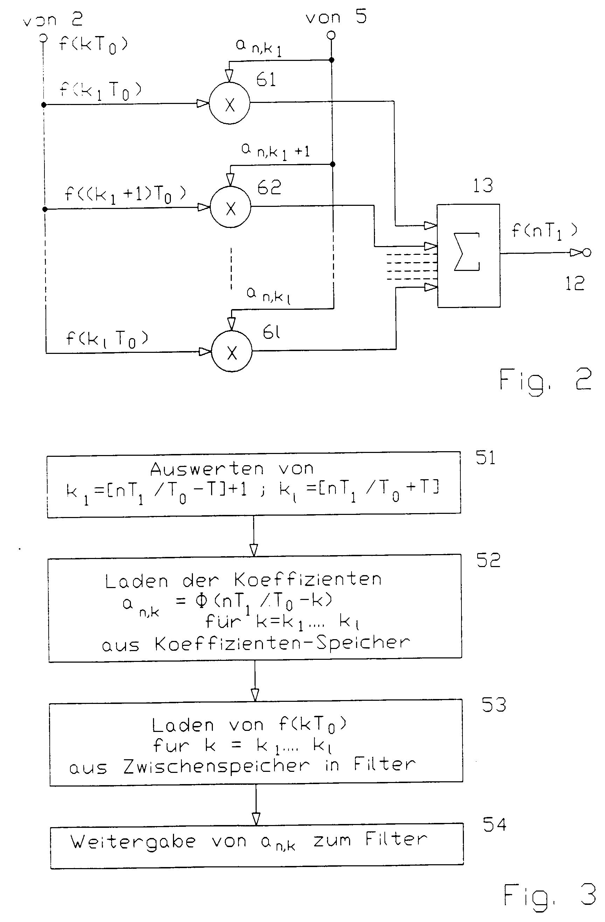

Das digitale Filter 6 kann sowohl - wie in Fig. 2 dargestellt - als Schaltung mit einzelnen Multiplizierern und einer Summierschaltung als auch mit Hilfe eines entsprechend programmierten Signalprozessors ausgeführt werden. Dieses gilt auch für die Steuerschaltung 5, für die wesentliche Teile eines Programms in Fig. 3 dargestellt sind. In einem ersten Schritt 51 werden $k_1$ und $k_l$ berechnet. Anschließend werden im Programmteil 52 die Koeffizienten aus dem Koeffizienten-Speicher geladen. Bei 43 werden die benötigten Abtastwerte aus dem Zwischenspeicher in das Filter überführt. Schließlich werden bei 54 die Koeffizienten an das Filter weitergegeben.

Bei dem Ausführungsbeispiel nach Fig. 4 werden die jeweils erforderlichen Koeffizienten fortlaufend berechnet. Dazu ist ein Signalprozessor 5 mit einem entsprechenden Programm vorgesehen. Der Signalprozessor übernimmt außerdem die Aufgaben der Auswahlschaltung 3 und der Steuerschaltung 5 nach Fig. 1. Ferner entfallen gegenüber der Anordnung nach Fig. 1 der Umschalter 7 und die Koeffizienten-Speicher 8 bis 10. Die anderen Baugruppen und die Funktion der Anordnung nach Fig. 4 entsprechen ansonsten denjenigen der Anordnung nach Fig. 1.

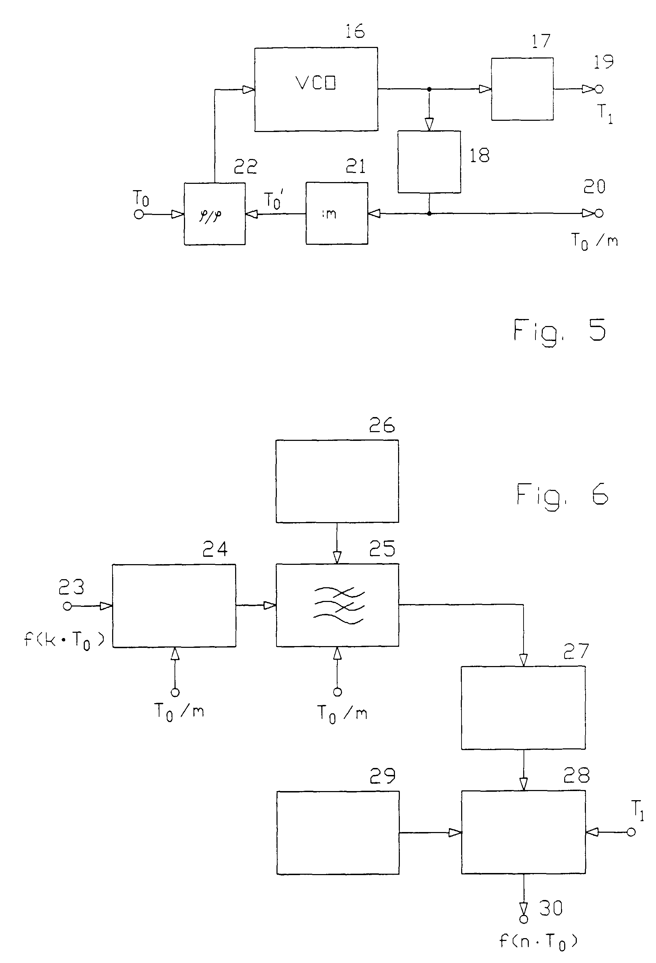

Ein weiteres Ausführungsbeispiel wird anhand der Figuren 5 und 6 erläutert. Davon zeigt Fig. 5 eine Schaltung zur Erzeugung von in der Anordnung nach Fig. 6 benötigten Taktsignalen. Insbesondere nimmt die Schaltung nach Fig. 5 eine Verkopplung des zweiten Taktsignals $T_1$ mit dem ersten Taktsignal $T_0$ vor. Dazu ist ein steuerbarer Oszillator 16 vorgesehen, dessen Ausgangssignal zwei Frequenzteilern 17, 18 zugeführt wird. Durch den Frequenzteiler 17 wird der Abtasttakt $T_1$ erzeugt. Dieser wird vom Ausgang 19 zu der Anordnung nach Fig. 6 geleitet.

Mit Hilfe des Frequenzteilers 18 wird ein Takt $T_0/m$ erzeugt und über einen Ausgang 20 der Anordnung nach Fig. 6 zugeführt. Am Ausgang eines weiteren Frequenzteilers 21 steht dann ein Signal $T_0'$ an, das zusammen mit dem

Signal $T_0$ einer Phasenvergleichsschaltung 22 zugeführt wird. Mit dem Ausgangssignal der Phasenvergleichsschaltung 22 wird in an sich bekannter Weise die Phase und die Frequenz des steuerbaren Oszillators 16 geregelt.

Ein Signal $f(k \cdot T_0)$ mit dem ersten Abtasttakt $T_0$ wird bei der Anordnung nach Fig. 6 zunächst einer Schaltung zur Überabtastung zugeführt. Diese besteht aus einer Schaltung 24, die mit dem "Überabtasttakt" $T_0/m$ angesteuert wird. Zwischen die einzelnen Abtastwerte des Signals $f(k \cdot T_0)$, die mit dem Abtasttakt $T_0$ auftreten, werden (m-1) Nullwerte eingefügt. Das somit erhaltene Signal wird über einen Tiefpaß 25 geleitet, dessen Koeffizienten in einem Koeffizientenspeicher 26 abgelegt sind. Der Tiefpaß 25 wird mit dem Überabtasttakt $T_0/m$ getaktet.

Mit dem Überabtasttakt $T_0/m$ wird das Signal auch aus dem Tiefpaß 25 ausgelesen und in einen Ringspeicher 27 eingeschrieben. Der Ringspeicher ist ein an sich bekannter Schreib/Lese-Speicher, bei welchem zum Schreiben und Lesen die einzelnen Speicherplätze unabhängig voneinander zyklisch adressiert werden. Das Auslesen aus dem Ringspeicher 27 erfolgt mit einem Takt von $T_1/k_s$, wobei $k_s$ eine natürliche Zahl ist.

Die aus dem Ringspeicher 27 ausgelesenen Werte werden einem digitalen Filter 28 zugeführt, das die folgende Gleichung realisiert:

$$f(n \cdot T_1) = \sum_{k=[n \cdot m \cdot T_1/T_0 - T]+1}^{[n \cdot m \cdot T_1/T_0 + T]} f(k \cdot T_0/m) \cdot \Phi(n \cdot m \cdot T_1/T_0 - k) \qquad (4)$$

Dabei ist T eine Zahl, für die $\Phi(x) = 0$, $|x| \geq T$ gilt. $f(k \cdot T_0/m)$ ist das in den Ringspeicher 27 eingelesene Signal.

Wegen der Periodizität $p = (T_0/m) \cdot kgV(m/T_0, 1/T_1)$, wobei kgV das kleinste gemeinschaftliche Vielfache bedeutet, in den Abtastraten und der Symmetrie in $\Phi$ braucht man nur $[p/2]+1$ Koeffizientensätze abzuspeichern, wobei $[p/2]$ die größte ganze Zahl ist, die kleiner oder gleich $p/2$ ist.

Als Beispiel seien Abtastperioden von $T_0 = 1/44100$ Hz, und $T_1 = 1/48000$ Hz angenommen. Bei m = 1, also ohne Überabtastung ergibt sich p = 160. Es sind also 81 Koeffizientensätze zu speichern. Bei einer Überabtastung von m = 4 wird dagegen p = 40, was 21 Koeffizientensätzen entspricht.

Jeder Koeffizientensatz besteht aus $k_s$ Koeffizienten und einer zugehörigen Zahl M, aus der sich die Adressen der aus dem Ringspeicher auszulesenden Werte berechnen lassen. M und $k_s$ können aus den Summationsgrenzen in Gleichung (4) berechnet werden. Bei günstigen Verhältnissen kann M eine feste Zahl sein, auf deren Abspeichern im Koeffizientenspeicher 29 verzichtet werden kann. Dem Ausgang 30 kann das Signal $f(n \cdot T_1)$ mit dem Abtasttakt $T_1$ entnommen werden.

Für einfache Anwendungen kann auf die Nachregelung des zweiten Abtasttaktes $T_1$ mit Hilfe der in Fig. 5 dargestellten Schaltungsanordnung verzichtet werden. Statt dessen können die Lese- und Schreibadressen des Ringspeichers verglichen werden. Aus der Änderung des Abstandes dieser Adressen kann eine Stellgröße zur Nachführung des Taktsignals $T_1$ abgeleitet werden.

**Patentansprüche**

1. Anordnung zur Umsetzung eines Signals mit einem ersten Abtasttakt $(T_0)$ in ein Signal mit einem zweiten Abtasttakt $(T_1)$, wobei einem digitalen Filter (6) Abtastwerte des Signals zugeführt werden und Koeffizienten des digitalen Filters (6) in Abhängigkeit von dem Verhältnis der Abtastraten $(T_1/T_0)$ gebildet werden und Abtastwerte mit dem zweiten Abtasttakt $(T_1)$ aus dem digitalen Filter (6) ausgelesen werden, dadurch gekennzeichnet, daß die Koeffizienten $a_{n,k}$ nach folgender Funktion gebildet werden:

$$a_{n,k} = \Phi(n \cdot T_1/T_0 - k)$$

für $k = k_1 \ldots k_l$, wobei l die Anzahl der Koeffizienten darstellt, n eine natürliche Zahl ist, $\Phi$ eine zeitbegrenzte Funktion mit der Zeitgrenze $T \geq 0$, d. h. $\Phi(t) = 0$ für $|t| \geq T$ ist, k eine Laufvariable im Bereich der natürlichen Zahlen ist, die von $k_1$ nach $k_l$ läuft, wobei

$k_1 = [nT_1/T_0 - T] + 1$ und $k_l = [nT_1/T_0 + T]$ ist, wobei die rechteckige Klammer in den Gleichungen für $k_1$ und $k_l$ die größte ganze Zahl darstellt, die kleiner oder gleich ihrem tatsächlichen Inhalt ist, und die Fourier-Transformierte $\Phi$ folgender Gleichung genügt:

$$D_j \hat{\Phi}(2\pi k) = \begin{cases} \delta_{j,0}, & k = 0 \\ 0, & k \neq 0 \end{cases} \qquad j = 0, \ldots, r$$

wobei $D^j$ die j-te-Ableitung von $\Phi$ an der Stelle $2\pi k$ ist, und $\delta_{j,0} = 1$ für $j = 0$ und $\delta_{j,0} = 0$ für $j \neq 0$ ist.

2. Anordnung nach Anspruch 1, dadurch gekennzeichnet, daß die Funktion $\Phi$ eine Linearkombination von E-Splines darstellt.

3. Anordnung nach einem der Ansprüche 1 oder 2, dadurch gekennzeichnet, daß das digitale Filter (6) ein FIR-Filter ist.

4. Anordnung nach einem der Ansprüche 1 bis 3, dadurch gekennzeichnet, daß das digitale Filter folgende Funktion realisiert:

$$f(n \cdot T_1) = \sum_{k=[nT_1/T_0-T]+1}^{[nT_1/T_0+T]} f(k \cdot T_0) \cdot \Phi(n \cdot T_1/T_0-k) + R(\Phi;T_0),$$

wobei $\Phi$ eine Funktion der Koeffizienten und R ein Approximationsfehler ist.

5. Anordnung nach einem der Ansprüche 1 bis 4, dadurch gekennzeichnet, daß die Koeffizienten für verschiedene vorkommende Verhältnisse der Abtastraten in einem Speicher (8, 9, 10) abgelegt sind und in Abhängigkeit von dem jeweils vorliegenden Verhältnis ausgelesen werden.

6. Anordnung nach einem der Ansprüche 1 bis 5, dadurch gekennzeichnet, daß ein Prozessor (15) vorgesehen ist, der fortlaufend die Koeffizienten in Abhängigkeit des Verhältnisses der Abtasttakte ($T_0$, $T_1$) berechnet.

7. Anordnung nach einem der Ansprüche 1 bis 6, dadurch gekennzeichnet, daß das Signal mit dem ersten Abtasttakt in einen Zwischenspeicher (2) eingeschrieben und vor dort in das digitale Filter (6) übertragen wird und daß in Abhängigkeit vom Füllungsgrad des Zwischenspeichers (2) der zweite Abtasttakt ($T_1$) geregelt wird.

8. Anordnung nach einem der Ansprüche 1 bis 7, dadurch gekennzeichnet, daß eine Steuerschaltung (5) vorgesehen ist, die in Abhängigkeit vom Verhältnis der Abtasttakte Koeffizienten aus einem Speicher (8, 9, 10) ausliest, die mit dem ersten Abtasttakt ($T_0$) in einen Zwischenspeicher (2) eingeschriebenen Signalwerte aus dem Zwischenspeicher (2) ausliest und dem digitalen Filter (6) zuführt.

9. Anordnung nach einem der Ansprüche 1 bis 8, dadurch gekennzeichnet, daß das Signal mit dem erste Abtasttakt über eine Einrichtung (24, 25) zur Überabtastung zuführbar ist.

10. Anordnung nach Anspruch 9, dadurch gekennzeichnet, daß die Einrichtung zur Überabtastung von einer Schaltung (24) zum Einfügen von Nullwerten zwischen die Abtastwerte des zugeführten Signals und vo einem Tiefpaß (25) gebildet ist.

11. Anordnung nach Anspruch 9, dadurch gekennzeichnet, daß zwischen der Einrichtung (24, 25) zur Überabtastung und dem digitalen Filter (6) ein Ringspeicher (27) angeordnet ist, in welchen das Signal mit dem Überabtasttakt eingeschrieben und mit einem ganzzahligen Bruchteil des zweiten Abtasttaktes ausgelesen wird.

12. Anordnung nach Anspruch 9, dadurch gekennzeichnet, daß ein steuerbarer Oszillator (16) ein Taktsignal mit einer Frequenz erzeuigt, die einem gemeinsamen Vielfachen der ersten und der zweiten Abtstrate entspricht und aus der durch Frequenzteilung die erste und zweite Abtastrate und fdie Überabtastrate abgeleitet werden.

13. Anordnung nach Anspruch 12, dadurch gekennzeichnet, daß eine Frequenz- und Phasenregelschleife (18, 21, 22) vorgesehen ist, welche das Taktsignal mit dem ersten Abtasttakt verkoppelt.

14. Anordnung nach Anspruch 13, dadurch gekennzeichnet, daß der zweite Abtasttakt durch Vergleich der Lese- und Schreibadresse des Ringspeichers (27) gerelgt wird.

## Claims

1. Arrangement for converting a signal with a first sampling clock ($T_0$) into a signal with a second sampling clock ($T_1$), sampled values of the signal being fed to a digital filter (6), and coefficients of the digital filter (6) being formed as a function of the ratio between the sampling rates ($T_1/T_0$), and sampled values being read out from the digital filter (6) using the second sampling clock ($T_1$), characterized in that the coefficients $a_{n,k}$ are formed according to the following function:

$$a_{n,k} = \Phi (n \cdot T_1/T_0 - k)$$

for $k = k_1...k_l$, where $l$ represents the number of coefficients, $n$ is a natural number, $\Phi$ is a time-limited function with the time limit $T \geq 0$, i.e. $\Phi (t) = 0$ for $ltl \geq T$, and $k$ is a control variable in the range of the natural numbers and runs from $k_1$ to $k_l$,

$k_1 = [nT_1/T_0 - T] + 1$ and $k_l = [nT_1/T_0 + T]$, where the square bracket in the equations represents the largest integral value for $k_1$ and $k_1$ which is less than or equal to their actual content, and the Fourier transform $\Phi$ satisfies the following equation:

$$D^j \Phi^\wedge (2\pi k) \;=\; \begin{cases} \delta_{j,0}, k = 0 \\ 0, k \neq 0 \end{cases} \quad j = 0, \ldots, r$$

$D^j$ being the j-th derivation of $\Phi$ at the point $2\pi k$, and $\delta_{j,0} = 1$ for $j = 0$ and $\delta_{j,0} = 0$ for $j \neq 0$.

2. Arrangement according to Claim 1, characterized in that the function $\Phi$ represents a linear combination of B splines.

3. Arrangement according to one of Claims 1 or 2, characterized in that the digital filter (6) is a FIR filter.

4. Arrangement according to one of Claims 1 to 3, characterized in that the digital filter realizes the following function:

$$f(n \cdot T_1) \;=\; \sum_{k=[nT_1/T_0-T]+1}^{[nT_1/T_0+T]} f(k \cdot T_0) \cdot \Phi(n \cdot T_1/T_0 - k) \;+\; R(\Phi; T_0),$$

where $\Phi$ is a function of the coefficients and R is an approximation error.

5. Arrangement according to one of Claims 1 to 4, characterized in that the coefficients for various ratios of the sampling rates which occur are stored in a memory (8, 9, 10) and are read out as a function of the respectively existing ratio.

6. Arrangement according to one of Claims 1 to 5, characterized in that a processor (15) is provided which continuously calculates the coefficients as a function of the ratio between the sampling clocks ($T_0$, $T_1$).

7. Arrangement according to one of Claims 1 to 6, characterized in that the signal is written into a buffer (2) with the first sampling clock and is transmitted from the said buffer (2) into the digital filter (6), and in that the second sampling clock ($T_1$) is regulated as a function of the degree to which the buffer (2) is filled.

8. Arrangement according to one of Claims 1 to 7, characterized in that a control circuit (5) is provided which reads out coefficients from a memory (8, 9, 10) as a function of the ratio between the sampling clocks, reads out from a buffer (2) the signal values which have been written into the buffer (2) with the first sampling clock ($T_0$) and feeds them to the digital filter (6).

9. Arrangement according to one of Claims 1 to 8, characterized in that the signal can be fed with the first sampling clock via a device (24, 25) for oversampling.

10. Arrangement according to Claim 9, characterized in that the device for oversampling is formed by a circuit (24) for inserting zero values between the sampled values of the fed-in signal and by a low-pass filter (25).

11. Arrangement according to Claim 9, characterized in that arranged between the device (24, 25) for oversampling and the digital filter (6) is a toroidal core store (27) into which the signal is written with the oversampling clock and is read out with a whole fraction of the second sampling clock.

12. Arrangement according to Claim 9, characterized in that a controllable oscillator (16) produces a clock signal with a frequency which corresponds to a common multiple of the first and second sampling rates and from which the first and second sampling rates and the oversampling rate are derived by means of frequency division.

13. Arrangement according to Claim 12, characterized in that a frequency and phase control loop (18, 21, 22) is provided which combines the clock signal with the first sampling clock.

14. Arrangement according to Claim 13, characterized in that the second sampling clock is regulated by comparing the read address and write address of the toroidal core store (27).

## Revendications

1. Dispositif de transformation d'un signal à une première fréquence d'échantillonnage ($T_0$) en un signal à une seconde fréquence d'échantillonnage ($T_1$), un filtre numérique (6) recevant les valeurs d'échantillonnage du signal et les coefficients du filtre numérique (6) étant formés en fonction du rapport des fréquences d'échantillonnage ($T_1/T_0$), les valeurs d'échantillonnage étant lues dans le filtre numérique (6) à la seconde fréquence d'échantillonnage ($T_1$), caractérisé en ce qu'on forme les coefficients $a_n$, k selon la fonction suivante :

$$a_n, k = \Phi(n \cdot T_1/T_0 - k)$$

$k = k_1...k_l$, l étant le nombre des coefficients, n étant un nombre naturel, $\Phi$ une fonction limitée dans le temps avec pour limite de temps $T \geq 0$, c'est-à-dire $\Phi(t) = 0$ pour $|t| \geq T$, k étant une variable courante appartenant au nombre naturel, compris entre $k_1$ et $k_l$, avec $k_1 = [nT_1/T_0 - T] + 1$ et $k_l = [nT_1/T_0 + T]$, les crochets dans les équations de $K_1$ et $k_l$ représentant le plus grand nombre entier inférieur ou égal au contenu effectif du crochet et la transformée de Fourier $\Phi$ satisfaisant à l'équation suivante :

$$\hat{D}^j \Phi(2\pi k) = \begin{cases} \delta_{j,0} & , \quad k = 0, \\ 0 & , \quad k \neq 0, \end{cases} j = 0, \ldots, r$$

dans laquelle $D^j$ représente la dérivée d'ordre j de la fonction $\Phi$ à l'endroit $2\pi k$ et $\delta_{j,0} = 1$ pour $j = 0$, $\delta_{j,0} = 0$ pour $j \neq 0$.

2. Dispositif selon la revendication 1, caractérisé en ce que la fonction $\Phi$ est une combinaison linéaire de fonction spline B.

3. Dispositif selon l'une des revendications 1 ou 2, caractérisé en ce que le filtre numérique (6) est un filtre FIR.

4. Dispositif selon l'une des revendications 1 à 3, caractérisé en ce que le filtre numérique réalise la fonction suivante :

$$f(n \cdot T_1) = \sum_{k=[nT_1/T_0-T]+1}^{[n \cdot m \cdot T_1/T_0+T]} f(k \cdot T_0) \cdot \Phi(n \cdot T_1/T_0 - k) + R(\Phi; T_0)$$

dans laquelle $\Phi$ est une fonction des coefficients et R une erreur d'approximation.

5. Dispositif selon l'une des revendications 1 à 4, caractérisé en ce que les coefficients des différents rapports existants des fréquences d'échantillonnage sont enregistrés dans une mémoire (8, 9, 10) et ces coefficients sont lus en fonction du rapport respectif existant.

6. Dispositif selon l'une des revendications 1 à 5, caractérisé par un processeur (15) calculant en continu les coefficients en fonction du rapport des fréquences d'échantillonnage ($T_0$, $T_1$).

7. Dispositif selon l'une des revendications 1 à 6, caractérisé en ce que le signal à la première fréquence d'échantillonnage est enregistré dans une mémoire intermédiaire (2) d'où il est transmis au filtre numérique (6) et la seconde fréquence d'échantillonnage ($T_1$) est réglée en fonction du degré de remplissage de la mémoire intermédiaire (2).

8. Dispositif selon l'une des revendications 1 à 7, caractérisé par un circuit de commande (5) qui lit les coefficients dans une mémoire (8, 9, 10) en fonction du rapport des fréquences d'échantillonnage, ce circuit lisant dans la mémoire intermédiaire (2) les valeurs des signaux enregistrés avec la première fréquence d'échantillonnage ($T_0$) dans la mémoire intermédiaire (2) pour les appliquer au filtre numérique (6).

9. Dispositif selon l'une des revendications 1 à 8, caractérisé en ce que le signal à la première fréquence d'échantillonnage est fourni par une installation (24, 25) pour un suréchantillonnage.

10. Dispositif selon la revendication 9, caractérisé en ce que l'installation de suréchantillonnage est formée d'un circuit (24) ajoutant les valeurs zéro entre les valeurs d'échantillonnage du signal reçu et comprenant un filtre passe-bas (25).

11. Dispositif selon la revendication 9, caractérisé par une mémoire en anneau (27) prévue entre l'installation (24, 25) de suréchantillonnage et le filtre numérique (6), mémoire en anneau dans laquelle on enregistre le signal à la fréquence de suréchantillonnage et dans lequel on le lit à l'aide d'une fraction entière de la seconde fréquence d'échantillonnage.

12. Dispositif selon la revendication 1, caractérisé en ce qu'un oscillateur commandé génère un signal de période à une fréquence correspondant au multiple commun de la première et de la seconde fréquence d'échantillonnage, obtenu par division de fréquence la première et la seconde fréquence d'échantillonnage ainsi que la fréquence de suréchantillonnage.

13. Dispositif selon la revendication 12, caractérisé par une boucle de régulation de fréquence et de phase (18, 21, 22) qui couple le signal de période à la première fréquence d'échantillonnage.

14. Dispositif selon la revendication 13, caractérisé en ce qu'il règle la seconde fréquence d'échantillonnage par comparaison de l'adresse de lecture et d'écriture de la mémoire en anneau (27).

Fig. 1

von 2

$f(kT_0)$

von 5

$a_{n,k_1}$

$f(k_1 T_0)$

61

X

13

$a_{n,k_1 +1}$

$f((k_1 +1)T_0)$

62

X

$\sum$

$f(nT_1)$

12

$a_{n,k_l}$

$f(k_l T_0)$

6l

X

Fig. 2

---

51

Auswerten von
$k_1 = [nT_1 /T_0 - T] + 1$ ; $k_l = [nT_1 /T_0 + T]$

---

52

Laden der Koeffizienten
$a_{n,k} = \Phi(nT_1 /T_0 - k)$
für $k = k_1 .... k_l$
aus Koeffizienten-Speicher

---

53

Laden von $f(kT_0)$
für $k = k_1 .... k_l$
aus Zwischenspeicher in Filter

---

54

Weitergabe von $a_{n,k}$ zum Filter

Fig. 3

Fig. 4

Fig. 5

Fig. 6